# EUROPEAN PATENT SPECIFICATION

(11) **EP 2 034 322 B1**
(45) Date of publication and mention of the grant of the patent: **23.01.2013**
(21) Application number: 07017504.7
(22) Date of filing: 06.09.2007
(51) Int. Cl.: H03K 5/1252, H03K 5/156, G01R 29/027, H03K 17/16, H03K 17/687

(54) **Control circuit for driving a semiconductor switch**
Steuerschaltung zur Ansteuerung eines Halbleiterschalters
Circuit de contrôle pour la commande d'un commutateur semi-conducteur

(43) Date of publication of application: 11.03.2009
(73) Proprietor: Infineon Technologies Austria AG, 9500 Villach (AT)
(72) Inventor: Galvano, Maurizio, 92015 Raffadali (AG) (IT)
(74) Representative: Patentanwälte Westphal, Mussgnug & Partner

(56) References cited:
- EP-A- 1 432 113
- US-A- 3 997 798
- US-B1- 6 510 068
- HERZER R ET AL: "A UNIVERSAL SMART CONTROL IC FOR HIGH-POWER IGBT APPLICATIONS" EPE '97. 7TH. EUROPEAN CONFERENCE ON POWER ELECTRONICS AND APPLICATIONS. TRONDHEIM, SEPT. 8 - 10, 1997, EPE . EUROPEAN CONFERENCE ON POWER ELECTRONICS AND APPLICATIONS, BRUSSELS, EPE ASSOCIATION, B, vol. VOL. 3 CONF. 7, 8 September 1997 (1997-09-08), pages 3098-3102, XP000768272 ISBN: 90-75815-02-6

## Description

The invention relates to a control circuit for driving a semiconductor switch, especially for driving a half bridge with a pulse-width-modulated input signal.

Power semiconductor switches such as MOSFETs and IGBTs usually can not be driven by a binary input signal that can only assume two different levels representing the logic states "0" and "1". For driving such power semiconductor switches special control circuits are usually employed in order to provide adequate driver signals to the semiconductor switches. The waveforms of the driver signals depend on the binary input signals but, for example, the waveform of the driver signal has to meet certain requirements dependent on the application. In many cases the maximum slope of a pulse of the driver signal is limited by the control circuit in order to reduce electromagnetic emissions during switching. Specifically manipulating the slope of the driver signal is generally referred to as "edge shaping". Of course, one control circuit can control more than one semiconductor switch. One control circuit typically controls the switching state of transistor bridges, e.g. half bridges.

However, if a transient pulse in the binary input signal is too short to enable the driver circuit to change the switching state of the semiconductor switch, the pulse will cause unwanted power dissipation in the control circuit due to cross-conduction and internal switching in the control circuit without having any effect on the semiconductor switch. This effect is even more evident in low power applications, since power dissipation has a greater effect on the overall efficiency of the system comprising control circuit and semiconductor switch.

A control circuit for driving a semiconductor switch comprising a short pulse suppression is known from the publication R. Herzer et. al: A universal smart control IC for high-power IGBT applications, in: EPE 1997, Trondheim, Proc. Vol. III, pp. 98 to 102. The publications US 6,510,068 B1 and EP 1 432 113 also relate to power electronics.

It is an object of the present invention to provide a control circuit with a reduced power dissipation due to short transient pulses of the input signal which are too short to have an effect on the semiconductor switch (or switches).

This object is achieved by a control circuit as recited in claim 1. Exemplary embodiments are covered by the dependent claims.

The control circuit can be employed for driving at least one semiconductor, i.e. single switches or transistor bridges. Each semiconductor switch has a control terminal for receiving a driver signal. The control circuit comprises:
a driver circuit adapted for generating the driver signal for the semiconductor switch, the driver signal being dependent on an input signal received by the control circuit, the input signal comprising pulses having a pulse length;
an observer circuit receiving the input signal, being adapted for detecting whether the pulse length of a received pulse of the input signal exceeds a critical pulse length;
a gate circuit receiving the input signal, connected to the observer circuit, and adapted for gating the input signal to the driver circuit dependent on the detection result provided by the observer circuit.

The gate circuit may be adapted for blanking out pulses subsequent to the received pulse in the input signal, that is supplied to the driver circuit, if the received pulse has a pulse length which does not exceed the critical pulse length. The pulses may be blanked out until the observer circuit has received a pulse having a pulse length exceeding the critical pulse length.

The critical pulse length is defined as the length of a pulse of the input signal that is just long enough to effect a change in the switching state of the semiconductor switch. The observer circuit may be adapted for adjusting the critical pulse length dependent on properties of the semiconductor switch connected to the control circuit and on properties of the driver circuit. This allows for an adaptive "filtering" of the pulses of the input signal. The term "filtering" is used for the procedure of blanking out pulses in the input signal which have a pulse width shorter than the critical pulse width. "Adaptive" here means that the critical pulse width is adapted to the system of control-circuit and semiconductor switch.

The following discussion explains.the invention in more detail based on the following figures:
- Figure 1: shows, as an exemplary embodiment of the invention, a control circuit for driving a semiconductor half-bridge. The control circuit comprises a driver circuit, an observer circuit, and a gate circuit. A load circuit is connected to an output of the half-bridge.
- Figure 2: shows a timing diagram of relevant signals in the circuit of Figure 1.
- Figure 3a: shows timing diagrams of the driver signal supplied to the high-side semiconductor switch by the control circuit of Fig. 1 compared to a driver signal of a conventional control circuit.
- Figure 3b: shows timing diagrams of the driver signal supplied to the low-side semiconductor switch by the control circuit of Fig. 1 compared to a driver signal of a conventional control circuit.
- Figure 4: shows one examplary embodiment of the observer circuit of Figure 1 in more detail. The observer circuit comprises a circuit for determining the critical pulse length and a detection circuit for detecting whether the pulse width of a pulse of the input signal exceeds a critical pulse length.
- Figure 5: shows one examplary embodiment of the circuit for determining the critical pulse length (cf. Figure 4) in more detail.
- Figure 6: shows one examplary embodiment of the detection circuit (cf. Figure 4) in more detail.
- Figure 7: shows timing diagrams of relevant signals in the detection circuit of Figure 6.

In the figures, unless otherwise indicated, the same reference notations refer to corresponding components or signals.

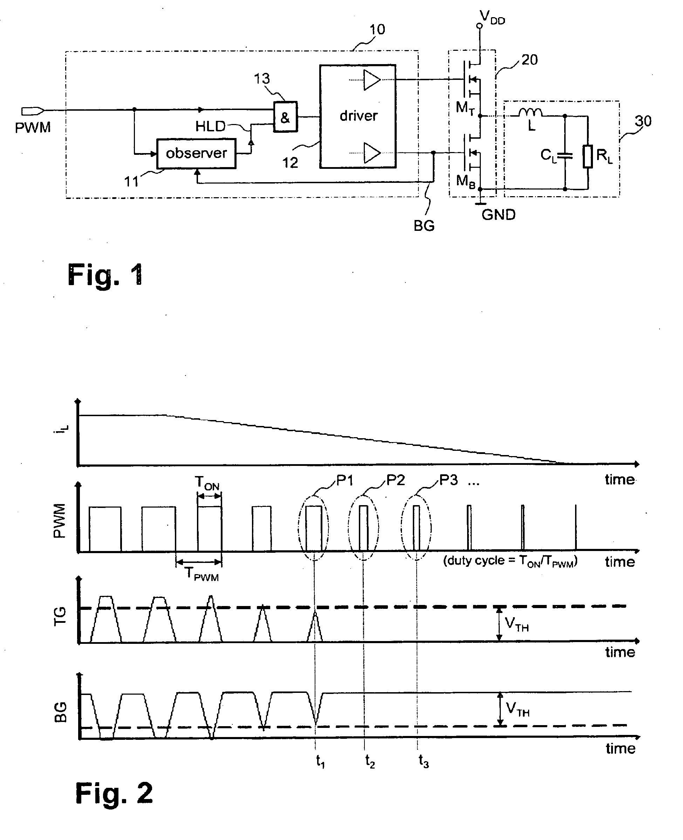

Figure 1 shows a circuit diagram comprising a transistor half-bridge 20, a control circuit 10 for driving the semiconductor switches M_{T}, M_{B}, and a load circuit 30 connected to an output node of the transistor half-bridge 20. The load circuit 30 represents a complex impedance which may comprise an inductor L, a capacitor C_{L} and a resistor R_{L}. The exact configuration of the load circuit 30 is not important for the further discussion and is therefore not explained in more detail.

The transistor half-bridge may comprise a top transistor M_{T} connected between a first supply terminal receiving an upper supply potential V_{DD} and an output node of the half-bridge 20 and a bottom transistor M_{B} connected between the output node and a second supply terminal receiving a reference potential (e.g. ground potential GND). Each transistor of the half-bridge 20 has a control terminal (referred to as gate terminals in the case of MOSFETs or IGBTs) which receive driver signals TG, BG from the control circuit 10. In the present example the control circuit 10 supplies a first driver signal BG to the control terminal of the bottom transistor M_{B} and a second driver signal TG to the control terminal of the top transistor M_{T} of the half-bridge 20. The driver signals BG, TG depend on an input signal PWM received by the control circuit 10. In the present example the top transistor M_{T} of the half-bridge 20 is switched on by the second driver signal TG in response to a high level in the input signal PWM, whereas the bottom transistor is switched off by the first driver signal BG. In response to a low level of the input level PWM the top transistor is switched off by the second driver signal TG and the bottom transistor is switched on by the first driver signal BG. If the input signal PWM is, for example, a pulse-width modulated signal, the mean output current i_{L} provided at the output node of the half-bridge 20 to the load circuit 30 is substantially proportional to the duty cycle of the pulse-width modulated input signal PWM.

It has to be noted that all logic levels of signals depicted in the figures or explained in the description have to be understood as examples. Any logic signal can be inverted by replacing a respective logic component by its inverting counterpart.

The control circuit 10 comprises a driver circuit 12 for generating driver signals BG, TG for the semiconductor switches connected to the control circuit 10. The driver circuit 12 is adapted for generating the driver signals BG, TG it dependent on the input signal PWM which is gated to the driver circuit 12 by means of a gate circuit 13 (e.g. an AND-gate). The gate circuit 13, e.g. the AND-gate, receives the input signal PWM and a hold signal HLD and provides a "filtered" input signal PWM' to the driver logic, wherein the filtered input signal PWM' is either equal to the input signal PWM (apart from the negligible propagation delay of the gate circuit 30) or equal to a low-level signal dependent on the logic level (ON or OFF) of the hold signal HLD. That is, the gate circuit 13 gates the input signal PWM to the driver circuit 12 dependent on the logic level of the hold signal HLD. The hold signal HLD is provided by an observer circuit 11 also receiving the input signal PWM and one of the driver signals BG, TG. In the present example the observer circuit 11 receives the second driver signal BG.

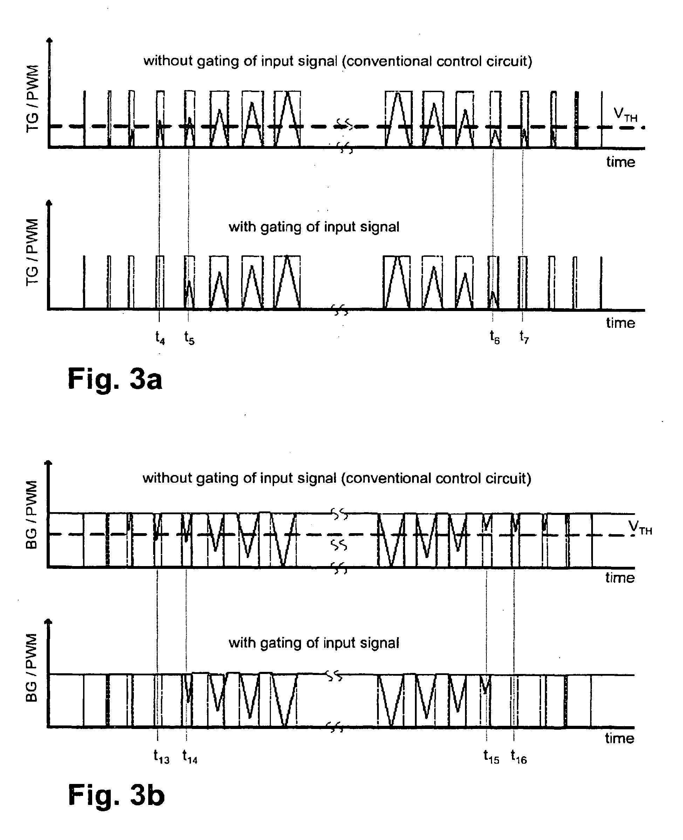

The basic function of the observer circuit 11, the gate circuit 13 and the driver circuit 12 is best explained with reference to the timing diagrams depicted in figure 2 and figures 3a and 3b. In the example of figure 2 the input signal PWM is a pulse-width modulated signal with a cycle time T_{PWM}, an "on-time" T_{ON}, and an "off-time" T_{PWM}-T_{ON} as depicted in the second timing diagram of figure 2, wherein the on-time T_{ON} is defined as the pulse length of a ON-pulse in the pulse-width modulated signal, that is the time the pulse-width modulated signal is in an ON-state (also referred to as "logic 1" or "high level"). In the further discussion the term "pulse" (e.g. pulses P1, P2, and P3 of figure 2) denotes an ON-pulse of an pulse-width modulated signal. As mentioned above, logic levels are interchangeable dependent if a negative logic or a positive logic is used. The applicability of the present control circuit 10 is not restricted to pulse-width modulated input signals either.

A pulse in the input signal (cf. second diagram of figure 2) triggers a corresponding pulse in the respective driver signal TG or BG, wherein the waveform of the driver signal TG (or BG respectively) is not rectangular like the waveform of the input signal PWM. The driver circuit 12 which generates the driver signals BG, TG typically limits the slope of pulses in the driver signal in order to reduce undesired electromagnetic emissions and to reduce electromagnetic interference (EMI). The pulses of the driver signal TG (cf. third diagram of figure 2) essentially correspond to the pulses of the input signal PWM, but the waveform is rather trapezoidal than rectangular. The pulses of the driver signal BG (cf. fourth diagram of figure 2) essentially are inverted versions of the pulses of the driver signal TG.

In a circuit as depicted in figure 1 the load current I_{L} through the load circuit 30 is substantially proportional to the duty cycle (i.e. ratio T_{ON}/T_{PWM}) of the input signal PWM. If the load current I_{L} is to be ramped down as shown in the first timing diagram of figure 2, the "on-time" (i.e. the pulse-length T_{ON}) of the pulses of the input signal PWM is short and consequently the duty cycle T_{ON/}T_{PWM} is small.

If the pulse length T_{ON} decreases, the pulse length of the pulses of the driver signal also decreases and the waveform becomes substantially triangular. The amplitude of the pulses decreases with decreasing pulse length T_{ON}, due to the limited slope. When the pulse length of an input signal pulse (here denoted by P1) is too short to trigger a corresponding driver signal (TG) pulse that is high enough in amplitude (i.e. exceeding the threshold voltage V_{TH} of the respective transistor M_{T}) to switch on the respective semiconductor switch (M_{T}), then subsequent pulses (P2, P3, ...) of the input signal PWM are blanked out by the gate circuit 13 in order to avoid undesired power dissipation in the driver circuit 12. The same principle may be applied to pulses that are too short to trigger a corresponding driver signal (BG) pulse that is high enough in amplitude (i.e. falling below the threshold voltage V_{TH} of the respective transistor M_{B}) to switch off the respective semiconductor switch (M_{B}). Therefore the observer circuit is adapted for detecting whether the pulse length T_{ON} of a received pulse P1 of the input signal PWM exceeds a critical pulse length T_{CRIT} or not. The input signal PWM is then gated to the driver circuit 12 dependent on the detection result. That is, if the received pulse P1 of the input signal PWM does not exceed the critical pulse length T_{CRIT}, then all subsequently received pulses P2, P3, ... of the input signal PWM are blanked out by means of the gate circuit 13, thus yielding a "filtered" input signal PWM'. This filtered input signal is then supplied to the driver circuit 12. As can be seen from figure 2, pulses whose pulse T_{ON} length does not exceed the critical pulse length T_{CRIT} are blanked out and no corresponding driver signal pulses are generated by the driver circuit 12, since such pulses could not switch on the respective semiconductor switch anyway. Unwanted power dissipation is thus avoided.

Of course the pulses P2, P3, ... subsequent to the pulse P1 whose pulse length does not exceed the critical pulse length T_{CRIT} should not be blanked out ad infinitum. As illustrated in the second diagram of figure 3a, the gate circuit 13 stops blanking out the pulses of the input signal PWM as soon as a pulse has been received whose pulse length exceeds the critical pulse length T_{CRIT}. That is pulses are blanked out only until a pulse is detected whose pulse length whose pulse length is long enough to effect a change in the switching state of the half bridge 20.

Figure 3a depicts the effect of the control circuit 10 of figure 1 by comparing the driver high-side signal TG provided by the control circuit of figure 1 (cf. second diagram of figure 3) with driver signals provided by a conventional control circuit (cf. first diagram of figure 3). As soon as (e.g. at time t₄) the pulse length of a received pulse of the input signal PWM is long enough and does exceed the critical pulse length T_{CRIT}, a blanking is stopped for all subsequent pulses and the input signal is gated through the gate circuit 13 to the driver circuit 12 which generates respective driver signals shown in figure 3a (e.g. from time t₅ to t₆). This is done until (e.g. until time t₇) the observer circuit 11 receives a pulse with a pulse length shorter than the critical pulse length T_{CRIT}. If this is the case all subsequent pulses are suppressed (blanked out) until a sufficiently long pulse is received. Figure 3b depicts the effect of the control circuit 10 of figure 1 by comparing the low-side driver signal BG provided by the control circuit of figure 1 (cf. second diagram of figure 3b) with driver signals provided by a conventional control circuit (cf. first diagram of figure 3b).

In this case pulses which are too short to switch off the low-side semiconductor switch are blanked out. In this case blanking out is not to be understood as "setting to zero" (i.e. the lower rail of the driver signal voltage) but as "setting to voltage V_{DD}" (i.e. the voltage representing the upper rail of the driver signal voltage). As soon as (e.g. at time t₁₃) the pulse length of a received pulse of the input signal PWM is long enough and does exceed the critical pulse length T_{CRIT}, a blanking is stopped for all subsequent pulses and the input signal is gated to the driver circuit 12 which generates respective driver signals shown in figure 3b (e.g. from time t₁₄ to t₁₅). This is done until (e.g. until time t₁₆) the observer circuit 11 receives a pulse with a pulse length shorter than the critical pulse length T_{CRIT}. If this is the case all subsequent pulses are suppressed (blanked out) until a sufficiently long pulse is received.

The critical pulse width T_{CRIT} depends on properties of the driver circuit (e.g. the maximum slope of the driver signal), of the semiconductor switch (e.g. the gate-source capacitance, gate resistance, threshold voltage, etc.) and of the interconnection of driver circuit and semiconductor switch (e.g. additional gate resistors and capacitors for reducing glitches). Since different semiconductor switches can be operated with the same control circuit 10 the control circuit has to measure the critical pulse length T_{CRIT} for the transistors actually connected to the control circuit 10. Therefore, in one example of the invention, the observer circuit 11 is adapted for adjusting the critical pulse length T_{CRIT} dependent on properties of the semiconductor switch M_{B}, M_{T} connected to the control circuit 10, especially dependent on the gate-source capacitance if the connected semiconductor switch is a field effect transistor. The adjusting of the critical pulse length T_{CRIT} can be performed at startup of the control circuit 10 and optionally be repeated during operation of the control circuit 10, for example, in regular time intervals or if temperature has changed by more than a certain value.

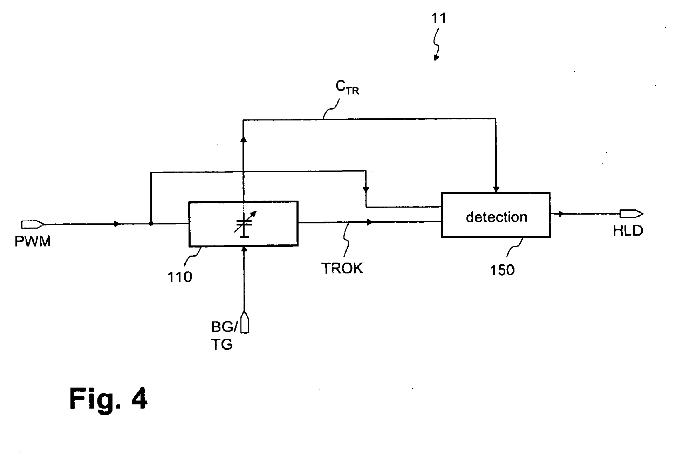

The observer circuit depicted in figure 1 is explained in more detail with reference to figure 4 including this special feature of adjusting the critical pulse length T_{CRIT}. The observer circuit 11 receives the input signal PWM and at least one of the driver signals BG, TG and provides the hold signal HLD being supplied to the gate circuit 13 (cf. figure 1). The observer circuit comprises a circuit 110 for determining the critical pulse length T_{CRIT} and a detection circuit for detecting whether or not the length of a received pulse (cf. pulses P1, P2, P3 of figure 2) of the input signal (PWM) exceeds the critical pulse length T_{CRIT}. The detection result is signalled to the gate circuit 13 via the hold signal HLD.

The circuit 110 for determining the critical pulse length T_{CRIT} may comprise a variable capacitor having an adjustable capacitance value which is set such that it represents the critical pulse length T_{CRIT}. The input signal PWM and the driver signal BG (TG) is supplied to circuit 110. The circuit 110 is adapted for measuring the delay between an edge in the input signal PWM and a corresponding edge in the driver signal BG (or TG) being supplied to the respective semiconductor switch M_{B} (or M_{T}). This delay is a good measure for the critical pulse length T_{CRIT} which is necessary to have any effect on the connected semiconductor switch. The circuit 110 may be further adapted for setting the capacitance value of a variable capacitor substantially proportional to the actual critical pulse length T_{CRIT}. The critical pulse length T_{CRIT} is thus "saved" for further processing of the input signal PWM. The finish of the determination of the critical pulse length T_{CRIT}, i.e. the finish of the trimming of the variable capacitor, is signalled to the detection circuit by a finish signal TROK.

The detection circuit 150 receives the input signal PWM and the finish signal TROK. It is connected to the variable capacitor of circuit 110 (cf. line C_{TR} in figure 4) and provides the hold signal HLD to the gate circuit signalling whether further pulses of the input signals should be blanked out as explained above with reference to figures 1 to 3. For the detection the critical pulse length T_{CRIT} is determined by the capacitance value of the variable capacitor as explained above.

The detection circuit only operates if finish signal TROK indicates that a critical pulse width T_{CRIT} has successfully determined by circuit 110. If the length of a received pulse (P1) of the input signal PWM does not exceed the critical pulse length T_{CRIT}, then the hold signal is set to a first logic level (e.g. a low level or OFF-state); if it does exceed the critical pulse length T_{CRIT}, then the hold signal is set to a second logic level (e.g. a high level or ON-state). It should be noted that logic levels can always be inverted if the circuit is appropriately modified, thus the explanation has to be understood as an example.

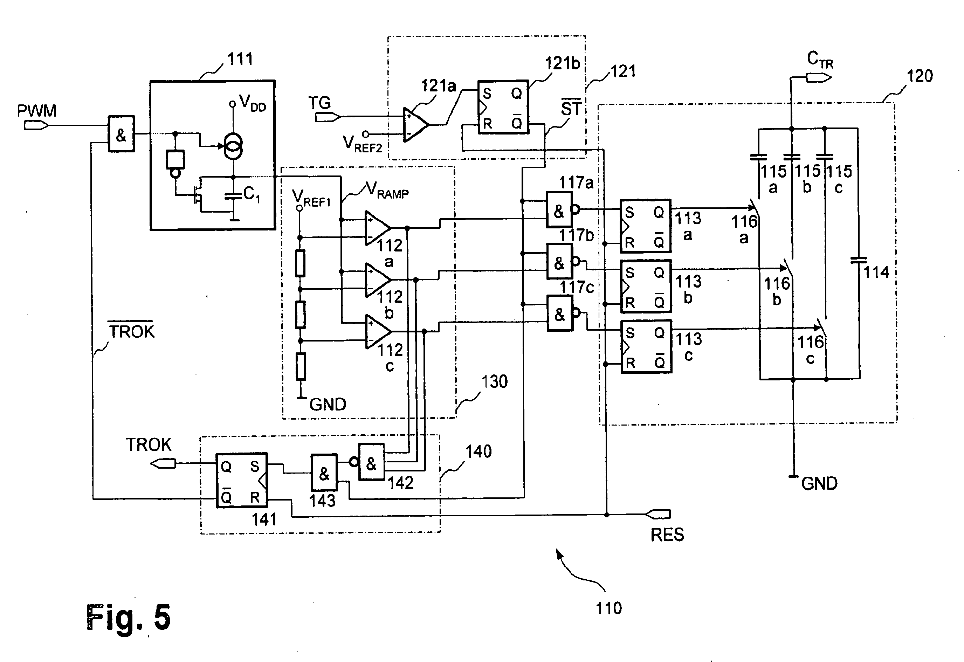

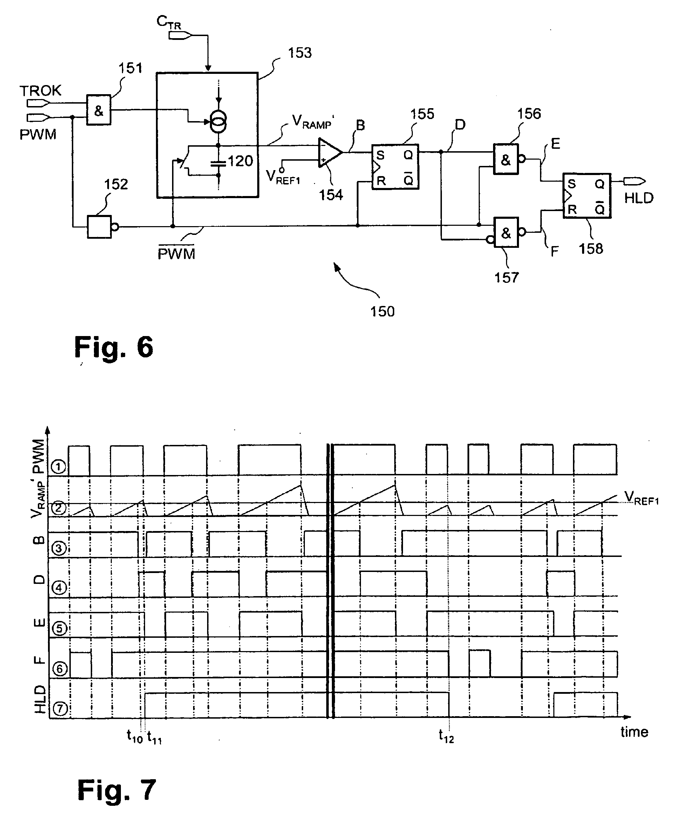

Examples of the circuit 110 for determining the critical pulse length T_{CRIT} and of the detection circuit 150 are depicted in figures 5 and 6 respectively. Measurement of the critical pulse length starts with resetting circuit 140 with a reset signal RES. The capacitance value of the variable capacitor 120 is thereby reset to a defined value (i.e. capacitance value of capacitor 114). The reset signal RES is supplied to the reset-input of a flip-flop 141 of a reset circuit 140. The non-inverting output of flip-flop 141 provides the finish signal TROK which is set to a low level in response to a reset pulse of the reset signal RES indicating that the determination of the critical pulse length T_{CRIT} is busy.

Circuit 110 comprises a controllable ramp generator 111 controlled by an output signal of an AND-gate 118 which receives as inputs the input signal PWM and the inverted finish signal /TROK (i.e. "NOT TROK"). A "new" ramp-shaped pulse (ramp signal V_{RAMP}) with a defined slope is triggered by a pulse in the input signal if the inverted finish signal /TROK has a high level which is always the case directly after a reset of flip-flop 141.

The ramp signal V_{RAMP} is supplied to the compare circuit 130 that comprises comparators 112a, 112b, 112c, AND-gates 119a, 119b and a voltage divider providing each comparator 112a, 112b, 112c with a reference potential which is a fractional of the reference potential V_{REF1}. For example, the reference potential for comparator 112c is V_{REF1}/3, the reference potential for comparator 112b is 2V_{REF1}/3, and the reference potential for comparator 112c is V_{REF1}/3, the reference potential for comparator 112a is V_{REF1}. The ramp signal V_{RAMP} is supplied to the non-inverting inputs of the comparators 112a, 112b, 112c such that the output of each comparator goes high if the level of the ramp signal V_{RAMP} exceeds the reference potential of the respective comparator 112a, 112b, 112c.

The outputs of the comparators 112a, 112b, 112c form the outputs of the compare circuit 130. If the amplitude of the ramp signal V_{RAMP} goes up from zero to its peak value, the outputs of the comparators 112a, 112b, 112c will subsequently go high each after a certain time dependent from the slope of the ramp signal and from the reference potentials received by the comparators 112a, 112b, 112c.

The outputs of the compare circuit are supplied to the variable capacitor via NAND-gates 117a, 117b, 117c. One NAND-gate is provided for each comparator. Each NAND-gate 117a, 117b, 117c receives as inputs the output signal from the respective comparator 112a, 112b, 112c and the output ST of a comparator block 121 which goes high if the driver signal TG exceeds a second reference potential V_{REF2}. In essence, the output ST of the comparator block 121 goes high on rising edge in the driver signal TG which corresponds to a rising edge in the input signal PWM. The NAND-gates 117a, 117b, 117c therefore "forward" (and invert) the output signals of the comparators 112a, 112b, 112c to the variable capacitor 120 as long as no rising edge in the driver signal TG is received by the comparator block 121, that is after the delay time between pulse of the input signal PWM and a corresponding pulse in the driver signal TG (or BG) has expired, the output signals of the comparators are suppressed by the NAND-gates 117a, 117b, 117c.

The comparator block 121 comprises a comparator 121a and a falling edge triggered flip-flop 121b. Comparator 121a generates a falling edge if TG exceeds the second reference potential V_{REF2}, thus setting the flip-flop 121b. The inverting output of flip-flop 121b is used as output for the comparator block 121 which goes low if TG exceeds the second reference potential V_{REF2}, thus "blocking" the NAND-gates 117a, 117b, 117c. Flip-flop 121b is also reset by the reset signal RES. If the driver signal BG is used instead of TG, comparator 121a has to be connected such that its output goes low when the driver signal BG falls below the second reference potential V_{REF2}, i.e. the inverting and the non-inverting input of comparator 121 have to be interchanged (compared to figure 5).

The variable capacitor 120 comprises a first capacitor 114 and further capacitors 115a, 115b, 115c which may be connected in parallel to the first capacitor 114 by means of switches 116a, 116b, 116c. The total capacitance of the parallel circuitry depends on how many capacitors are switched in parallel. The variable capacitor 120 further comprises flip-flops 113a, 113b, 113c, wherein the output of each flip-flop is connected to a respective switch 116a, 116b, 116c. A switch 116a, 116b, 116c is closed and the respective capacitor 115a, 115b, 115c is connected in parallel to the first capacitor 114 in response to a set-pulse supplied to the respective flip-flop 113a, 113b, 113c. The flip-flops 113a, 113b, 113c are reset by the reset signal RES. The set-inputs of the flip-flops 113a, 113b, 113c are connected to the outputs of the NAND-gates 117a, 117b, 117c. It has to be noted that there is one NAND-gate 117a, 117b, 117c and one flip-flop 113a, 113b, 113c per comparator 112a, 112b, 112c. Of course four or more comparators can be provided if a higher resolution is required.

If the ramp signal V_{RAMP} has exceeded the first reference potential V_{REF1} before the driver signal TG has exceeded the second reference potential V_{REF2}, then the capacitance of the variable capacitor 120 is set to its maximum value and and flip-flop 141 of the reset circuit 140 is set by means AND-gate 143. The inverting output /TROK of flip flop 141 "deactivates" the whole circuit 110. If the ramp signal V_{RAMP} does not exceed the first reference potential V_{REF1} before the driver signal TG exceeds the second reference potential V_{REF2}, then the actual capacitance value at the time the driver signal TG exceeds the second reference potential V_{REF2} is "stored" by setting flip-flop 141 of the reset circuit 140 by means of NAND-gate 142 and AND-gate 143. The inverting output /TROK of flip flop 141 deactivates the whole circuit 110, too, in this case. In essence the circuit 110 is deactivated on the rising edge of driver signal TG or when the ramp signal V_{RAMP} exceeds the first reference potential V_{REF1}, whatever occurs earlier.

The function of the overall circuit can be summarised as follows:
- Resetting the circuit, especially all flip-flops (141, 113a, 113b, 113c) by the reset signal RES. The finish signal TROK goes low.
- Generating a ramp signal V_{RAMP}, wherein a ramp pulse is triggered by a pulse of the input signal PWM (if TROK is low).
- Comparing the level of the ramp signal V_{RAMP} with a plurality of monotonically increasing reference potentials by means of a plurality of comparators.
- Increasing the capacitance of the variable capacitor each time a comparator signals that a reference potential has been exceeded by the ramp signal V_{RAMP} as long as no pulse of the driver signal TG (or BG) is received by circuit 110.
- Setting the finish signal TROK to a high level after the ramp signal has exceeded all reference potentials thus blocking the generation of further ramp pulses.

After the finish signal TROK signals, that the determination of the critical pulse length has been finished, the capacitance value of the variable capacitor 120 is (apart from quantization errors) proportional to the time delay between a pulse in the input signal PWM and a corresponding pulse in the driver signal TG. This time delay is a measure of the critical pulse length T_{CRIT}.

Figure 6 depicts one example of the detection circuit 150 of figure 4. The detection circuit comprises an AND-gate 151 receiving the input signal PWM and the finish signal TROK and a ramp generator 153 controlled by the output of the AND-gate 151 and providing a ramp signal V_{RAMP}' which is triggered by a pulse in the input signal PWM if the finish signal TROK signals that the determination of the critical pulse length T_{CRIT} has finished. The slope of the is determined by the variable capacitor 120 which is connected to the ramp generator 153 with line C_{TR}. The level of the ramp signal V_{RAMP}' is compared to the reference potential V_{REF1} by comparator 154 whose output signal B provides a falling edge to the set-input of a flip-flop 155 if the level of the ramp signal V_{RAMP}' exceeds the reference potential V_{REF1}. The reset-input receives the inverted input signal /PWM provided by inverter 152. The non-inverting output provides a signal D to the NAND-gates 156 and 157 which receive as inputs the inverted input signal /PWM and the output signal D of the flip-flop 155, wherein the output signal D is inverted at the input of NAND-gate 157. The output of NAND-gate 156 (signal E) is connected to the set-input of a further flip-flop 158, and the output of NAND-gate 157 (signal F) is connected to the reset-input of the further flip-flop 158. The non-inverting output of the further flip-flop 158 provides the hold signal HLD.

The function of the detection circuit 150 is explained below with reference to figure 7. The diagram no. 1 of figure 7 illustrates one example of the input signal PWM comprising ONpulses with an increasing pulse length on the left side of the diagram and with a decreasing pulse length on the right side of the diagram (on right side of the vertical double bar). It is assumed that the critical pulse length has already been determined by circuit 110 (cf. figure 5) and the capacitance value of the variable capacitor 120 is set accordingly. As explained above a ramp pulse of the ramp signal V_{RAMP}' is triggered by a each pulse of the input signal PWM, an example of the ramp signal V_{RAMP}' can be seen in diagram no. 2 of figure 7. Before time t₁₀ the pulses of the input signal PWM are shorter than the critical pulse length T_{CRIT}, therefore the ramp pulses of the ramp signal V_{RAMP}' do not reach the reference potential level V_{REF1}, and the comparator 154 can not set the flip-flop 155. The signal B (diagram no. 3) and the signal E (diagram no. 5) remain at a high level, the further flip-flop 158 is not set, and the hold signal HLD is at a low level for blanking out the pulses in the input signal PWM as explained above. It has to be noted, that as in figure 4 all flip-flops are triggered by falling edges.

At a time t₁₀ the ramp signal V_{RAMP}' exceeds the reference potential level V_{REF1}, consequently comparator output (signal B, diagram no. 3) goes low thus setting flip-flop 155. As a result the output of the flip-flop 155 goes high (signal D, diagram no. 4) and at with the next falling edge of the input signal PWM at time t₁₁ the output of NAND-gate 156 goes low (signal E, diagram no. 5) thus setting the further flip-flop 158 yielding a high-level hold signal HLD (diagram no. 7). From time t₁₁ on the blanking out of input signal pulses is stopped until another pulse of the input signal PWM is detected that has a pulse length shorter than the critical pulse length T_{CRIT}, that is until another ramp pulse of the ramp signal V_{RAMP}' does not reach the reference potential level V_{REF1} within a pulse length of the respective input signal pulse.

At a time t₁₂ the actual ramp signal V_{RAMP}' did not exceed the reference potential level V_{REF1} before the end of the respective pulse of the input signal PWM. It can be concluded that the pulse length of this pulse did not exceed the critical pulse length T_{CRIT}. Consequently flip-flop 155 is not set during the cycle period, signal D remains lo and the output of NAND-gate 157 (signal F, diagram no. 6) goes low at the falling edge of the respecting input signal pulse at time t₁₂, thus resetting the further flip-flop 158 and die hold signal HLD goes low again. The subsequent pulses of the input signal PWM are blanked out as explained above.

The function of the overall control circuit is summarized below. It executes a method for driving a semiconductor switch comprising the following steps A to C:
(A) receiving an input signal PWM comprising pulses having a pulse length;
(B) detecting whether the pulse length of a received pulse P1 (cf. figure 2) exceeds a critical pulse length;
(C) gating the input signal PWM to the driver circuit 12 dependent on the detection result.

Step C comprises the step of blanking out pulses P2, P3 subsequent to the received pulse P1 in the input signal PWM, if the detected pulse length does not exceed the critical pulse length. The input signal PWM is thus modified and the modified input signal PWM' is supplied to the driver circuit 12 which generates respective driver signals TG, BG for the semiconductor switches M_{T}, M_{B}. The blanking out is performed until a pulse is received which has a pulse length exceeding the critical pulse length.

## Claims

1. A control circuit (10) for driving at least one semiconductor switch (M_{B}, M_{T}) having a control terminal for receiving a driver signal (BG, TG), the control circuit (10) comprising:
a driver circuit (12) adapted for generating the driver signal (TG, BG) for the semiconductor switch (M_{T}, M_{B}), the driver signal being dependent on an input signal (PWM) received by the control circuit (10), the input signal (PWM) comprising pulses having a pulse length;
an observer circuit (11) receiving the input signal (PWM), comprising a circuit (110) for determining a critical pulse length (T_{CRIT}), and being adapted for detecting whether the pulse length of a received pulse (P1) of the input signal (PWM) exceeds the critical pulse length (T_{CRIT}) ;
a gate circuit (13) receiving the input signal (PWM), connected to the observer circuit (11), and adapted for gating the input signal (PWM) to the driver circuit (12) dependent on the detection result of the observer circuit (11)
**characterised in that** the circuit for determining the critical pulse length (T_{CRIT}) (110) comprises an adjustable capacitor (120) which is set such that its capacitance represents the critical pulse length (T_{CRIT}), and the capacitance is adjusted dependent on a delay between a pulse of the input signal (PWM) and a respective pulse of the driver signal (BG, TG).

2. The control circuit of claim 1, where the circuit (110) for determining the critical pulse length comprises:
- a ramp generator (111) that provides a ramp signal (V_{RAMP}) of a defined slope in phase with the input signal (PWM),
- a plurality of comparators (112a, 112b, 112c) receiving the ramp signal (V_{RAMP}), each comparator (112a, 112b, 112c) having an individual threshold level,
- a plurality of flip-flops (113a, 113b, 113c) each connected to an output of one respective comparator (113a, 113b, 113c) via gates (117a, 117b, 117c),
- a plurality of capacitors (115a, 115b, 115c) each having a switch (116a, 116b, 116c) connected in series, each switch having a control terminal being connected with an respective output of one flip-flop (113a, 113b, 113c), where each capacitor (115a, 115b, 115c) is connected in parallel to a further capacitor (114) if the respective switch (116a, 116b, 116c) is closed, thus forming the adjustable capacitor (120).

3. The control circuit of claim 2, where a switch (116a, 116b, 116c) is closed if the respective comparator signals that the ramp signal (V_{RAMP}) has exceeded the respective threshold level before the driver signal (BG, TG) changes its state.

4. The control circuit of one of the claims 1 to 3, where the capacitance of the parallel circuitry (120) of the capacitors (114, 115a, 115b, 115c) is a measure for the minimum pulse length necessary to switch on the semiconductor switch (M_{B}, M_{T}) and thus represents the critical pulse length.

5. The control circuit of one of the claims 1 to 4, where the observer circuit (11) comprises a detection circuit (150) adapted for detecting whether the length of a pulse of the input signal (PWM) exceeds the critical pulse length.

6. The control circuit of claim 5, where the detection circuit (150) comprises a ramp generator (151) providing a ramp signal (V_{RAMP'}) whose slope depends on the capacitance of the adjustable capacitor (150).

7. The control circuit of claim 6, where the detection circuit (150) comprises logic circuitry adapted for
- setting the hold signal (HLD) to a first logic level, if the length of the received pulse (P1) in the input signal (PWM) is shorter than the time necessary for the ramp signal (V_{RAMP'}) to ramp up to a defined reference potential (V_{REF1}), and for
- setting the hold signal (HLD) back to a second logic level, if the length of the received pulse (P1) in the input signal (PWM) is longer than the time necessary for the ramp signal (V_{RAMP'}) to ramp up to the defined reference potential (V_{REF1}).

8. The control circuit (10) of one of the claims 1 to 7, where the gate circuit (13) is adapted for blanking out pulses (P2, P3) subsequent to the received pulse (P1) in the input signal (PWM), that is supplied to the driver circuit (12), if the received pulse (P1) has a pulse length which does not exceed the critical pulse length.

9. The control circuit of one of the claims 1 to 8, where the gate circuit (13) is adapted for blanking out pulses (P2, P3) subsequent to the received pulse (P1) in the input signal (PWM), until the observer circuit (11) has received a pulse having a pulse length exceeding the critical pulse length.

10. The control circuit of one of the claims 1 to 9, where the critical pulse length is defined as the length of a pulse of the input signal (PWM) that is just long enough to effect a change in the switching state of the semiconductor switch (M_{B}, M_{T}).

11. The control circuit of one the claims 1 to 10, where the observer circuit (11) is adapted for adjusting the critical pulse length dependent on properties of the semiconductor switch (M_{B}, M_{T}) connected to the control circuit (10).

12. The control circuit of one the claims 1 to 11, where the observer circuit (11) is adapted for signalling to the gate circuit (13) via a hold signal (HLD) whether to blank out a pulse in the input signal (PWM) or not.

13. The control circuit of claim 12, where the observer circuit (11) is adapted for
- setting the hold signal (HLD) to a first logic level if a pulse is received whose pulse length does not exceed the critical pulse length, and for
- setting the hold signal (HLD) to a second logic level if a pulse is received whose pulse length exceeds the critical pulse length.

14. The control circuit of claim 13, where the gate circuit (13) is adapted for blanking out the pulses of the input signal (PWM) as long the hold signal (HLD) is set to the first logic level.

15. The control circuit of one of the claims 1 to 14, where the gate circuit comprises an AND-gate receiving the input signal (PWM) and the hold signal (HLD) and providing a filtered version (PWM') of the input signal to the driver circuit (12).

16. The control circuit of claim 15, where the AND-gate has a defined time-delay and where the delay between the input signal (PWM) and the filtered version (PWM') of the input signal equals the time-delay of the AND-gate.

17. A method for driving a semiconductor switch comprising the following steps:
(A) receiving an input signal (PWM) comprising pulses having a pulse length;
(B) detecting whether the pulse length of a received pulse (P1) exceeds a critical pulse length;
(C) gating the input signal (PWM) to the driver circuit (12) dependent on the detection result,
**characterised in that** step B includes the step of
determining the critical pulse length (T_{CRIT}) by setting an adjustable capacitor (120) such that its capacitance (C_{TR}) represents the critical pulse length (T_{CRIT}), wherein the capacitance (C_{TR}) is adjusted dependent on a delay between a pulse of the input signal (PWM) and a respective pulse of the driver signal (BG, TG).

18. The method of claim 17, where step C comprises the step of blanking out pulses (P2, P3) subsequent to the received pulse (P1) in the input signal (PWM), if the detected pulse length does not exceed the critical pulse length, thus modifying the input signal (PWM) and supplying the modified input signal (PWM') to the driver circuit (12).

19. The method of claim 17, where step C comprises the step of blanking out pulses (P2, P3) subsequent to the received pulse (P1) in the input signal (PWM), if the detected pulse length does not exceed the critical pulse length, thus modifying the input signal (PWM) and supplying the modified input signal (PWM') to the driver circuit (12) until a pulse is received having a pulse length exceeding the critical pulse length.

## Patentansprüche

1. Steuerschaltung (10) zum Steuern von mindestens einem Halbleiterschalter (M_{B}, M_{T}), der einen Steueranschluss zum Empfangen eines Treibersignals (BG, TG) besitzt, wobei die Steuerschaltung (10) Folgendes umfasst:
eine Treiberschaltung (12), die ausgelegt ist, das Treibersignal (TG, BG) für den Halbleiterschalter (M_{T}, M_{B}) zu erzeugen, wobei das Treibersignal von einem durch die Steuerschaltung (10) empfangenen Eingangssignal (PWM) abhängig ist, wobei das Eingangssignal (PWM) Impulse umfasst, die eine Impulslänge besitzen;
eine Überwachungsschaltung (11), die das Eingangssignal (PWM) empfängt, eine Schaltung (110) zum Bestimmen einer kritischen Impulslänge (T_{CRIT}) umfasst und ausgelegt ist, zu ermitteln, ob die Impulslänge eines empfangenen Impulses (P1) des Eingangssignals (PWM) die kritische Impulslänge (T_{CRIT}) übersteigt;
eine Gate-Schaltung (13), die das Eingangssignal (PWM) empfängt, mit der Überwachungsschaltung (11) verbunden ist und ausgelegt ist, das Eingangssignal (PWM) abhängig von dem Ermittlungsergebnis der Überwachungsschaltung (11) an die Treiberschaltung (12) zu leiten,
**dadurch gekennzeichnet, dass** die Schaltung zum Bestimmen der kritischen Impulslänge (T_{CRIT}) (110) einen anpassbaren Kondensator (120) umfasst, der so eingestellt ist, dass seine Kapazität die kritische Impulslänge (T_{CRIT}) repräsentiert und die Kapazität abhängig von einer Verzögerung zwischen einem Impuls des Eingangssignals (PWM) und einem entsprechenden Impuls des Treibersignals (BG, TG) angepasst wird.

2. Steuerschaltung nach Anspruch 1, wobei die Schaltung (110) zum Bestimmen der kritischen Impulslänge Folgendes umfasst:
- einen Rampengenerator (111), der ein mit dem Eingangssignal (PWM) gleichphasiges Rampensignal (V_{RAMP}) mit einer festgelegten Steigung liefert,
- mehrere Komparatoren (112a, 112b, 112c), die das Rampensignal (V_{RAMP}) empfangen, wobei jeder Komparator (112a, 112b, 112c) einen individuellen Grenzpegel besitzt,
- mehrere Flipflops (113a, 133b, 113c), die alle mit einem Ausgang eines entsprechenden Komparators (113a, 113b, 113c) über Gates (117a, 117b, 117c) verbunden sind,
- mehrere Kondensatoren (115a, 115b, 115c), die alle einen Schalter (116a, 116b, 116c) besitzen, der in Serie angeschlossen ist, wobei jeder Schalter einen Steueranschluss besitzt, der mit einem entsprechenden Ausgang eines Flipflops (113a, 113b, 113c) verbunden ist, wobei jeder Kondensator (115a, 115b, 115c) parallel zu einem weiteren Kondensator (114) angeschlossen ist, wenn der entsprechende Schalter (116a, 116b, 116c) geschlossen ist, wodurch der anpassbare Kondensator (120) gebildet wird.

3. Steuerschaltung nach Anspruch 2, wobei ein Schalter (116a, 116b, 116c) geschlossen wird, wenn der entsprechende Komparator signalisiert, dass das Rampensignal (V_{RAMP}) den entsprechen Grenzpegel übertroffen hat, bevor das Treibersignal (BG, TG) seinen Zustand ändert.

4. Steuerschaltung nach einem der Ansprüche 1 bis 3, wobei die Kapazität der Parallelschaltung (120) der Kondensatoren (114, 115a, 115b, 115c) ein Maß für die minimale Impulslänge ist, die notwendig ist, um den Halbleiterschalter (M_{B}, M_{T}) zu schalten, und daher die kritische Impulslänge repräsentiert.

5. Steuerschaltung nach einem der Ansprüche 1 bis 4, wobei die Überwachungsschaltung (11) eine Ermittlungsschaltung (150) umfasst, die ausgelegt ist, zu ermitteln, ob die Länge eines Impulses des Eingangssignals (PWM) die kritische Impulslänge übersteigt.

6. Steuerschaltung nach Anspruch 5, wobei die Ermittlungsschaltung (150) einen Rampengenerator (151) umfasst, der ein Rampensignal (V_{RAMP}) liefert, dessen Steigung von der Kapazität des anpassbaren Kondensators (150) abhängt.

7. Steuerschaltung nach Anspruch 6, wobei die Ermittlungsschaltung (150) einen logischen Schaltkreis umfasst, der ausgelegt ist zum:
- Einstellen des Hold-Signals (HLD) auf einen ersten logischen Pegel, wenn die Länge des empfangenen Impulses (P1) in dem Eingangssignal (PWM) kürzer als die Zeit ist, die das Rampensignal (V_{RAMP'}) benötigt, um zu einem festgelegten Referenzpotenzial (V_{REF1}) hochzulaufen, und zum
- Einstellen des Haltesignals (HLD) zurück auf einen zweiten logischen Pegel, wenn die Länge des empfangenen Impulses (P1) in dem Eingangssignal (PWM) länger als die Zeit ist, die das Rampensignal (V_{RAMP'}) benötigt, um zu einem festgelegten Referenzpotenzial (V_{REF1}) hochzulaufen.

8. Steuerschaltung (10) nach einem der Ansprüche 1 bis 7, wobei die Gate-Schaltung (13) ausgelegt ist, auf den empfangenen Impuls (P1) in dem Eingangssignal (PWM), das an die Steuerschaltung (12) geliefert wird, nachfolgende Impulse (P2, P3) auszublenden, wenn der empfangene Impuls (P1) eine Impulslänge besitzt, die die kritische Impulslänge nicht übersteigt.

9. Steuerschaltung nach einem der Ansprüche 1 bis 8, wobei die Gate-Schaltung (13) ausgelegt ist, auf den empfangenen Impuls (P1) in dem Eingangssignal (PWM) nachfolgende Impulse (P2, P3) auszublenden, bis die Überwachungsschaltung (11) einen Impuls empfangen hat, der eine Impulslänge besitzt, die die kritische Impulslänge übersteigt.

10. Steuerschaltung nach einem der Ansprüche 1 bis 9, wobei die kritische Impulslänge als die Länge eines Impulses des Eingangssignals (PWM), das gerade lang genug ist, um einen Wechsel in dem Schaltzustand des Halbleiterschalters (M_{B}, M_{T}) zu bewirken, definiert ist.

11. Steuerschaltung nach einem der Ansprüche 1 bis 10, wobei die Überwachungsschaltung (11) ausgelegt ist, die kritische Impulslänge abhängig von den Eigenschaften des mit der Steuerschaltung (10) verbundenen Halbleiterschalters (M_{B}, M_{T}) anzupassen.

12. Steuerschaltung nach einem der Ansprüche 1 bis 11, wobei die Überwachungsschaltung (11) ausgelegt ist, der Gate-Schaltung (13) über ein Hold-Signal (HLD) zu signalisieren, einen Impuls in dem Eingangssignal (PWM) auszublenden oder nicht.

13. Steuerschaltung nach Anspruch 12, wobei die Überwachungsschaltung (11) ausgelegt ist zum
- Einstellen des Haltesignals (HLD) auf einen ersten logischen Pegel, wenn ein Impuls empfangen wird, dessen Impulslänge die kritische Impulslänge nicht übersteigt, und zum
- Einstellen des Hold-Signals (HLD) auf einen zweiten logischen Pegel, wenn ein Impuls empfangen wird, dessen Impulslänge die kritische Impulslänge übersteigt.

14. Steuerschaltung nach Anspruch 13, wobei die Gate-Schaltung (13) ausgelegt ist, die Impulse des Eingangssignals (PWM) auszublenden, solange das Hold-Signal (HLD) auf den ersten logischen Pegel eingestellt ist.

15. Steuerschaltung nach einem der Ansprüche 1 bis 14, wobei die Gate-Schaltung ein UND-Gate umfasst, das das Eingangssignal (PWM) und das Haltesignal (HLD) empfängt und eine gefilterte Version (PWM') des Eingangssignals an die Steuerschaltung (12) liefert.

16. Steuerschaltung nach Anspruch 15, wobei das UND-Gate eine festgelegte Zeitverzögerung besitzt und wobei die Verzögerung zwischen dem Eingangssignal (PWM) und der gefilterten Version (PWM') des Eingangssignals gleich der Zeitverzögerung des UND-Gates ist.

17. Verfahren zum Steuern eines Halbleiterschalters, das die folgenden Schritte umfasst:
(A) Empfangen eines Eingangssignals (PWM), das Impulse umfasst, die eine Impulslänge besitzen;
(B) Ermitteln, ob die Impulslänge eines empfangenen Impulses (P1) eine kritische Impulslänge übersteigt;
(C) Leiten des Eingangssignals (PWM) abhängig von dem Ermittlungsergebnis an die Steuerschaltung (12),
**dadurch gekennzeichnet, dass** der Schritt B den folgenden Schritt enthält:
Bestimmen der kritischen Impulslänge (T_{CRIT}) durch Einstellen eines anpassbaren Kondensators (120), so dass seine Kapazität (C_{TR}) die kritische Impulslänge (T_{CRIT}) repräsentiert, wobei die Kapazität (C_{TR}) abhängig von einer Verzögerung zwischen einem Impuls des Eingangssignals (PWM) und einem entsprechenden Impuls des Treibersignals (BG, TG) angepasst wird.

18. Verfahren nach Anspruch 17, wobei der Schritt C den Schritt des Ausblendens von Impulsen (P2, P3), die dem empfangenen Impuls (P1) in dem Eingangssignal (PWM) nachfolgen, wenn die ermittelte Impulslänge die kritische Impulslänge nicht übersteigt, wodurch das Eingangssignal (PWM) geändert wird, und des Lieferns des geänderten Eingangssignals (PWM') an die Steuerschaltung (12) umfasst.

19. Verfahren nach Anspruch 17, wobei der Schritt C den Schritt des Ausblendens von Impulsen (P2, P3), die dem empfangenen Impuls (P1) in dem Eingangssignal (PWM) nachfolgen, wenn die ermittelte Impulslänge die kritische Impulslänge nicht übersteigt, wodurch das Eingangssignal (PWM) geändert wird, und des Lieferns des geänderten Eingangssignals (PWM') an die Steuerschaltung (12), bis ein Impuls empfangen wird, der eine Impulslänge besitzt, die die kritische Impulslänge übersteigt, umfasst.

## Revendications

1. Circuit (10) de commande pour attaquer au moins un commutateur (M_{B}, M_{T}) à semi-conducteur ayant une borne de commande pour recevoir un signal (BG, TG) d'attaque, le circuit (10) de commande comprenant :
un circuit (12) d'attaque, conçu pour produire le signal (BG, TG) d'attaque du commutateur (M_{T}, M_{B}) à semi-conducteur, le signal d'attaque dépendant d'un signal (PWM) d'entrée reçu par le signal (10) de commande, le signal (PWM) d'entrée comprenant des impulsions ayant une longueur d'impulsion ;
un circuit (11) d'observation, recevant le signal (PWM) d'entrée et comprenant un circuit (110) pour déterminer une longueur (T_{CRIT}) critique d'impulsion et conçu pour détecter si la longueur d'une impulsion (P1) reçue du signal (PWM) d'entrée dépasse la longueur (T_{CRIT}) critique d'impulsion ;
un circuit (13) à porte recevant le signal (PWM) d'entrée, relié au circuit (11) d'observation et conçu pour transmettre par la porte le signal (PWM) d'entrée au circuit (12) d'attaque en fonction des résultats de la détection du circuit (11) d'observation,
**caractérisé en ce que**, pour déterminer la longueur (T_{CRIT}) critique d'impulsion, le circuit (110) comprend un condensateur (120) réglable, qui est réglé de manière à ce que sa capacité représente la longueur (T_{CRIT}) critique d'impulsion et la capacité est réglée en fonction d'un retard entre une impulsion du signal (PWM) d'entrée et une impulsion respective du signal (BG, TG) d'attaque.

2. Circuit de commande suivant la revendication 1, dans lequel le circuit (110) pour la détermination de la longueur critique d'impulsion comprend :
- un générateur (111) de rampe, qui fournit un signal (V_{RAMP}) d'une pente définie en phase avec le signal (PWM) d'entrée,
- une pluralité de comparateurs (112a, 112b, 112c) recevant le signal (V_{RAMP}) de rampe, chaque comparateur (112a, 112b, 112c) ayant un niveau individuel de seuil,
- une pluralité de bascules (113a, 113b, 113c) reliées chacune à une sortie d'un comparateur (113a, 113b, 113c) respectif par des portes (117a, 117b, 117c),
- une pluralité de condensateurs (115a, 115b, 115c) ayant chacun un commutateur (116a, 116b, 116c) monté en série, chaque commutateur ayant une borne de commande reliée à une sortie respective d'une bascule (113a, 113b, 113c), chaque condensateur (115a, 115b, 115c) étant monté en parallèle à un autre condensateur (114) si le commutateur (116a, 116b, 116c) est fermé en formant ainsi le condensateur (120) réglable.

3. Circuit de commande suivant la revendication 2, dans lequel un commutateur (116a, 116b, 116c) est fermé si le comparateur respectif signale que le signal (V_{RAMP}) de rampe a dépassé le niveau respectif de seuil avant que le signal (BG, TG) d'attaque change d'état.

4. Circuit de commande suivant l'une des revendications 1 à 3, dans lequel la capacité du circuit (120) parallèle des condensateurs (114, 115a, 115b, 115c) est une mesure de la longueur minimum d'impulsion nécessaire pour fermer le commutateur (M_{B}, M_{T}) à semi-conducteur et représente ainsi la longueur critique d'impulsion.

5. Circuit de commande suivant l'une des revendications 1 à 4, dans lequel le circuit (11) d'observation comprend un circuit (150) de détection, conçu pour détecter si la longueur d'une impulsion du signal (PWM) d'entrée dépasse la longueur critique d'impulsion.

6. Circuit de commande suivant la revendication 5, dans lequel le circuit (150) de détection comprend un générateur (151) de rampe fournissant un signal (V_{RAMP'}) de rampe, dont la pente dépend de la capacité du condensateur (150) réglable.

7. Circuit de commande suivant la revendication 6, dans lequel le circuit (150) de détection comprend un montage logique conçu pour
- mettre le signal (HLD) de maintien à un premier niveau logique, si la longueur de l'impulsion (P1) reçue dans le signal (PWM) d'entrée est plus petite que le temps nécessaire pour que le signal (V_{RAMP'}) de rampe s'élève jusqu'à un potentiel (V_{REF1}) de référence défini, et pour
- remettre le signal (HLD) de maintien à un deuxième niveau logique, si la longueur de l'impulsion (P1) reçue dans le signal (PWM) d'entrée est plus grande que le temps nécessaire pour que le signal (V_{RAMP'}) de rampe s'élève au potentiel (V_{REF1}) de référence défini.

8. Circuit (10) de commande suivant l'une des revendications 1 à 7, dans lequel le circuit (13) à porte est conçu pour supprimer des impulsions (P2, P3) venant à la suite de l'impulsion (P1) reçue dans le signal (PWM) d'entrée, qui est fourni au circuit (12) d'attaque, si l'impulsion (P1) reçue a une longueur d'impulsion qui n'excède pas la longueur critique d'impulsion.

9. Circuit de commande suivant l'une des revendications 1 à 8, dans lequel le circuit (13) à porte est conçu pour supprimer des impulsions (P2, P3) venant à la suite de l'impulsion (P1) reçue dans le signal (PWM) d'entrée jusqu'à ce que le circuit (11) d'observation ait reçu une impulsion ayant une longueur d'impulsion dépassant la longueur critique d'impulsion.

10. Circuit de commande suivant l'une des revendications 1 à 9, dans lequel la longueur critique d'impulsion est définie comme étant la longueur d'une impulsion du signal (PWM) d'entrée qui est juste assez grande pour effectuer un changement de l'état de commutation du commutateur (M_{B}, M_{T}) à semi-conducteur.

11. Circuit de commande suivant l'une des revendications 1 à 10, dans lequel le circuit (11) d'observation est conçu pour régler la longueur critique d'impulsion en fonction de propriétés du commutateur (M_{B}, M_{T}) à semi-conducteur relié au circuit (10) de commande.

12. Circuit de commande suivant l'une des revendications 1 à 11, dans lequel le circuit (11) d'observation est conçu pour signaler au circuit (13) à porte, par l'intermédiaire d'un signal (HLD) de maintien, s'il faut supprimer une impulsion dans le signal (PWM) d'entrée ou ne pas la supprimer.

13. Circuit de commande suivant la revendication 12, dans lequel le circuit (11) d'observation est conçu pour
- mettre le signal (HLD) de maintien à un premier niveau logique, s'il est reçu une impulsion dont la longueur ne dépasse pas la longueur critique d'impulsion et pour
- mettre le signal (HLD) de maintien à un deuxième niveau logique, s'il est reçu une impulsion dont la longueur dépasse la longueur critique d'impulsion.

14. Circuit de commande suivant la revendication 13, dans lequel le circuit (13) à porte est conçu pour supprimer les impulsions du signal (PWM) d'impulsion tant que le signal (HLD) de maintien est mis au premier niveau logique.

15. Circuit de commande suivant l'une des revendications 1 à 14, dans lequel le circuit à porte comprend une porte ET recevant le signal (PWM) d'entrée et le signal (HLD) de maintien et fournissant une version (PWM') filtrée du signal d'entrée au circuit (12) d'attaque.

16. Circuit de commande suivant la revendication 15, dans lequel la porte ET a un retard défini et dans lequel le retard entre le signal (PWM) d'entrée et la version (PWM') filtrée du signal d'entrée est égal au retard de la porte ET.

17. Procédé d'attaque d'un commutateur à semi-conducteur comprenant les stades suivants :
(A) la réception d'un signal (PWM) d'entrée comprenant des impulsions ayant une longueur d'impulsion ;
(B) la détection du point de savoir si la longueur d'impulsion d'une impulsion (P1) reçue dépasse une longueur critique d'impulsion ;
(C) la transmission par porte du signal (PWM) d'entrée au circuit (12) d'attaque en fonction du résultat de la détection,
**caractérisé en ce que** le stade B comprend le stade de
détermination de la longueur (T_{CRIT}) critique d'impulsion en réglant un condensateur (120) réglable de manière à ce que sa capacité (C_{TR}) représente la longueur (T_{CRIT}) critique d'impulsion, la capacité (C_{TR}) étant réglée en fonction d'un retard entre une impulsion du signal (PWM) d'entrée et une impulsion respective du signal (BG, TG) d'attaque.

18. Procédé suivant la revendication 17, dans lequel le stade C comprend le stade de suppression d'impulsions (P2, P3) venant à la suite de l'impulsion (P1) reçue dans le signal (PWM) d'entrée, si la longueur d'impulsion détectée ne dépasse pas la longueur critique d'impulsion, en modifiant ainsi le signal (PWM) d'entrée et en fournissant le signal (PWM') d'entrée modifié au circuit (12) d'attaque.

19. Procédé suivant la revendication 17, dans lequel le stade C comprend le stade de suppression d'impulsions (P2, P3) venant à la suite de l'impulsion (P1) reçue dans le signal (PWM) d'entrée, si la longueur d'impulsion détectée ne dépasse pas la longueur critique d'impulsion, en modifiant ainsi le signal (PWM) d'entrée et en fournissant le signal (PWM') d'entrée modifié au circuit (12) d'attaque jusqu'à réception d'une impulsion ayant une longueur dépassant la longueur critique d'impulsion.
